# EUROPÄISCHE PATENTSCHRIFT

(11) **EP 4 042 476 B1**
(45) Veröffentlichungstag und Bekanntmachung des Hinweises auf die Patenterteilung: **13.12.2023**
(21) Anmeldenummer: 20786557.7
(22) Anmeldetag: 06.10.2020
(51) Int. Cl.: H01L 23/495, H05K 3/30, H01L 23/367, H05K 1/02

(54) **LEISTUNGSHALBLEITERBAUTEIL SOWIE VERFAHREN ZUR HERSTELLUNG EINES LEISTUNGSHALBLEITERBAUTEILS**
POWER SEMICONDUCTOR COMPONENT AND METHOD FOR PRODUCING A POWER SEMICONDUCTOR COMPONENT
COMPOSANT SEMI-CONDUCTEUR DE PUISSANCE ET PROCÉDÉ DE PRODUCTION DE COMPOSANT SEMI-CONDUCTEUR DE PUISSANCE

(30) Priorität: 10.10.2019 DE 102019215503
(43) Veröffentlichungstag der Anmeldung: 17.08.2022
(73) Patentinhaber: Vitesco Technologies GmbH, 93055 Regensburg (DE)
(72) Erfinder: QUEST-MATT, Christina, 81737 München (DE); BAGUNG, Detlev, 81737 München (DE); WOLF, Daniela, 81737 München (DE)
(74) Vertreter: Vitesco Technologies
(86) Internationale Anmeldenummer: PCT/EP2020/078019
(87) Internationale Veröffentlichungsnummer: WO 2021/069451

(56) Entgegenhaltungen:
- CN-A- 101 980 360
- JP-A- 2018 120 991
- US-A1- 2006 091 509

## Beschreibung

Die vorliegende Erfindung betrifft ein Leistungshalbleiterbauteil mit einem innerhalb eines Gehäuses angeordneten Leistungshalbleiterbauelement sowie ein Verfahren zur Herstellung eines Leistungshalbleiterbauteils.

Leistungshalbleiterbauelemente wie zum Beispiel MOSFETs werden in Gehäusen, typischerweise Kunststoffgehäusen, mit an der Gehäuseaußenseite freiliegenden Kühlflächen, beispielsweise aus Kupfer, angeordnet, wobei es eine Reihe unterschiedlicher Gehäusebauformen gibt, wie beispielsweise D2PAK, DPAK, TO220 etc. Die Bauelemente sind teilweise als oberflächenmontierbare Bauelemente ausgebildet und teilweise als durchsteckmontierbare Bauelemente. Sie weisen typischerweise zumindest zwei Anschlusspins auf, die aus dem Kunststoffgehäuse herausgeführt sind und mit Anschlüssen eines Verdrahtungssubstrats verbindbar sind.

Da Leistungshalbleiterbauteile, die derartige Leistungshalbleiterbauelemente aufweisen, im Betrieb hohe Wärmemengen abgeben, stellt das effiziente Abführen dieser Wärme eine besondere Herausforderung dar. Typischerweise wird die Wärme über das Verdrahtungssubstrat abgeführt, auf dem das gehäuste Leistungshalbleiterbauelement angeordnet ist. Dieses kann dazu beispielsweise thermische Bohrungen (Vias) aufweisen. Ein derartiges Leistungshalbleiterbauteil ist aus der JP 2018-120991 A bekannt.

Die DE 11 2016 005 508 T5 offenbart ebenfalls die Entwärmung über Vias, die ganz oder teilweise mit Lot gefüllt sein können. Ein rund um die Vias aufgebrachter Lötstopplack, auf den das Leistungshalbleiterbauelement aufgesetzt wird, kann gemäß einer Ausführungsform verhindern, dass Lot in die Vias fließt.

Bei manchen neueren Anwendungen, beispielsweise bei in Elektrofahrzeugen eingesetzten Ladegeräten, fallen sehr hohe Verlustleistungen an, sodass der Kühlung besondere Bedeutung zukommt. Teilweise ist bei derartigen Anwendungen der Einsatz thermischer Bohrungen aufgrund elektrischer Isolationsverordnungen auch nicht möglich. Es ist daher eine Aufgabe der vorliegenden Erfindung, ein Leistungshalbleiterbauteil anzugeben, das eine besonders wirksame Abfuhr von durch das Leistungshalbleiterbauelement abgegebener Wärme aufweist. Ferner soll ein Verfahren zur Herstellung eines derartigen Leistungshalbleiterbauteils angegeben werden.

Diese Aufgabe wird gelöst durch den Gegenstand der unabhängigen Ansprüche. Vorteilhafte Ausführungsformen und Weiterbildungen sind Gegenstand der Unteransprüche.

Gemäß einem Aspekt der Erfindung wird ein Leistungshalbleiterbauteil angegeben, das mindestens ein innerhalb eines Gehäuses angeordnetes Leistungshalbleiterbauelement aufweist, wobei an einer ersten Oberfläche des Gehäuses ein Kühlkörper freiliegt. Bei dem Gehäuse handelt es sich insbesondere um ein Kunststoffgehäuse. Der Kühlkörper ist insbesondere aus Metall ausgebildet. Das Gehäuse kann beispielsweise im Wesentlichen eine Quaderform aufweisen.

Das Leistungshalbleiterbauteil weist ferner ein Verdrahtungssubstrat mit einer ersten Hauptoberfläche und einer zweiten Hauptoberfläche auf. Bei dem Verdrahtungssubstrat kann es sich insbesondere um ein PCB-Substrat handeln, d.h. um eine gedruckte Leiterplatte. In diesem Fall handelt es sich bei dem Leistungshalbeiterbauteil insbesondere um eine Leiterplattenanordnung. Auf der zweiten Hauptoberfläche ist eine Entwärmungsregion mit erhöhter Wärmeleitfähigkeit angeordnet. Beispielsweise ist die Entwärmungsregion von einer an der zweiten Hauptoberfläche des Verdrahtungssubstrats angeordneten Kupfer-Lage der Leiterplatte gebildet.

Das Gehäuse ist derart auf dem Verdrahtungssubstrat angeordnet, dass der Kühlkörper über eine Lotschicht mit der Entwärmungsregion verbunden ist. In die Lotschicht ist eine Anzahl von zwischen dem Kühlkörper und der Entwärmungsregion angeordneten Abstandshaltern eingebettet. Die Abstandshalter sind insbesondere mit Vorteil aus einem elektrisch und thermisch gut leitenden Material ausgebildet.

Bei den Abstandshaltern kann es sich insbesondere um SMD-Klebepunkte handeln, das heißt punktuell aufgebrachte Mengen von SMD-Klebstoff. Unter einem SMD-Klebstoff wird dabei ein Klebstoff verstanden, der zur Fixierung oberflächenmontierbarer Bauteile (surface mount devices) verwendet wird. Solche Klebstoffe, bei denen es sich beispielsweise um elektrisch leitfähige Klebstoffe auf Epoxidharzbasis handeln kann, sind dem Fachmann prinzipiell bekannt und werden daher an dieser Stelle nicht näher erläutert. Die SMD-Klebepunkte können direkt auf dem Material der Entwärmungsregion oder auf einen auf die Entwärmungsregion aufgebrachten Lötstopplacksteg angeordnet sein.

Das Leistungshalbleiterbauteil hat den Vorteil, dass durch die Verwendung der Abstandshalter ein größerer Abstand zwischen Gehäuse und Verdrahtungssubstrat erzielbar ist, so dass eine dickere Lotschicht zwischen Gehäuse und Verdrahtungssubstrat aufgebracht werden kann. Dadurch wird die Menge an Lot und damit die Masse an gut wärmeleitendem Material auf dem Verdrahtungssubstrat stark erhöht. Sie kann insbesondere veranderthalbfacht oder sogar mehr als verdoppelt werden. Auf diese Weise wird die Wärme besonders wirksam aus dem Leistungshalbleiterbauelement abgeführt und an die Umgebung abgegeben.

Darüber hinaus stellt die große Menge gut wärmeleitfähigen Materials in thermischem Kontakt mit dem Kühlkörper einen Puffer dar, um kurzzeitige Leistungsspitzen des Leistungshalbleiterbauelements, die einen kurzzeitigen Temperaturanstieg bewirken, abzufangen.

Das Gehäuse mit dem Halbleiterbauelement ist derart auf der zweiten Hauptoberfläche des Verdrahtungssubstrats angeordnet, dass der Kühlkörper vollständig auf der Entwärmungsregion angeordnet und mit dieser über eine Lotschicht verbunden ist.

Zusätzlich kann auch die Dicke der Entwärmungsregion vergrößert werden. Typischerweise steht bei der Standardleiterplattentechnologie pro Lage maximal 70 Mikrometer Kupfer zur Verfügung, teilweise auch bis zu 105 Mikrometer oder bis zu 201 Mikrometer. Diese maximale Dicke kann für die Entwärmungsregion voll ausgeschöpft werden, um die wärmeleitende Masse zu maximieren.

Gemäß einer Ausführungsform ist das die Entwärmungsregion bildende Material, insbesondere Kupfer oder eine Kupferlegierung, in einer Matrix aus Kunststoffmaterial des Verdrahtungssubstrats eingebettet und die Oberfläche der Entwärmungsregion damit koplanar zur übrigen Oberfläche des Verdrahtungssubstrats. Alternativ könnte die Entwärmungsregion auch auf einer Oberfläche des Verdrahtungssubstrats aufliegen.

Gemäß einer Ausführungsform ist das in dem Gehäuse angeordnete Leistungshalbleiterbauelement durchsteckmontierbar ausgebildet. Bei dieser Ausführungsform weist das Leistungshalbleiterbauelement Anschlusspins auf, die aus dem Gehäuse ragen und die dazu vorgesehen sind, in Durchgangslöcher des Verdrahtungssubstrats eingesteckt zu werden. Dort werden sie anschließend verlötet. Bei dieser Ausführungsform ist es möglich, die Vias (Durchgangslöcher) des Verdrahtungssubstrats dazu zu nutzen, eine große Menge von Lotmaterial zwischen den Kühlkörper und die Entwärmungsregion des Verdrahtungssubstrats einzubringen. Gemäß einer Ausführungsform weist das Verdrahtungssubstrat daher eine Anzahl von Vias in der Entwärmungsregion auf, durch die das Lotmaterial zwischen den Kühlkörper und die Entwärmungsregion des Verdrahtungssubstrats eingebracht ist. Bei einem derartigen Verdrahtungssubstrat werden die Abstandshalter zwischen den Vias aufgebracht, sodass sie diese nicht verdecken.

Diese Ausführungsform weist den Vorteil auf, dass mit einem THT(through hole technology)-Lotprozess eine große Menge von Lot unter das Gehäuse gepumpt werden kann. Damit ist es möglich, eine hohe Dicke der Lotschicht zu erzielen, was bei einer aufgedruckten Lotschicht nur schwer möglich wäre.

Gemäß einer alternativen Ausführungsform ist das in dem Gehäuse angeordnete Leistungshalbleiterbauelement oberflächenmontierbar ausgebildet. Bei dieser Ausführungsform ragen aus dem Gehäuse ebenfalls Anschlusspins, die jedoch zum Auflöten auf Kontaktanschlussflächen auf dem Verdrahtungssubstrat vorgesehen sind und nicht zum Stecken in Durchgangslöcher.

Bei dieser Ausführungsform können trotzdem Vias vorgesehen sein, um Lotmaterial unter das Gehäuse zu bringen. Alternativ kann jedoch das Gehäuse mit dem Leistungshalbleiterbauelement nach einem Fixieren mittels der Abstandshalter mittels eines Lotdrahtes bzw. Lotdrahtstücken mit der Entwärmungsregion verbunden sein. Bei dieser Ausführungsform wird die Lotschicht demnach nicht durch Aufdrucken oder Pumpen in den Zwischenraum zwischen dem Gehäuse und der Entwärmungsregion eingebracht, sondern durch Einlegen von Lotdrahtstücken. Auch mit dieser Ausführungsform lässt sich eine erhebliche Dicke der Lotschicht und somit eine große wärmeleitende Masse erzielen.

Gemäß einer Ausführungsform weist der Kühlkörper eine Fläche a auf der ersten Oberfläche auf und die Entwärmungsregion weist eine Fläche A auf der zweiten Hauptoberfläche auf, wobei a < A gilt. Insbesondere kann a < 0,75 A oder sogar a < 0,5 A gelten. Diese Ausführungsform hat den Vorteil, dass durch die große Fläche der Entwärmungsregion die Menge an wärmeleitendem Material vergrößert wird. Darüber hinaus wird durch die große Entwärmungsregion, die seitlich über das Gehäuse mit dem Leistungshalbleiterbauelement hinausragt, eine besonders gute Wärmespreizung erzielt. Die Abgabe von Wärme an die Umgebung wird somit verbessert.

Gemäß einem Aspekt der Erfindung wird ein Verfahren zur Herstellung des beschriebenen Leistungshalbleiterbauteils angegeben, das das Bereitstellen eines innerhalb eines Gehäuses angeordneten Leistungshalbleiterbauelements umfasst, wobei an einer ersten Oberfläche des Gehäuses ein Kühlkörper freiliegt. Ferner wird ein Verdrahtungssubstrat mit einer ersten Hauptoberfläche und einer zweiten Hauptoberfläche bereitgestellt, wobei auf der zweiten Hauptoberfläche eine Entwärmungsregion mit erhöhter Wärmeleitfähigkeit angeordnet ist.

Eine Anzahl von Abstandshaltern wird in einer Montageregion der Entwärmungsregion auf das Verdrahtungssubstrat aufgebracht und das Gehäuse mit dem Leistungshalbleiterbauelement wird in der Montageregion auf die Abstandshalter aufgesetzt. In einen Zwischenraum zwischen dem Kühlkörper und der Entwärmungsregion wird ein Lotmaterial eingebracht.

Als Montageregion wird die zur Aufnahme des Gehäuses mit dem Leistungshalbleiterbauelement vorgesehene Region bezeichnet. Sie entspricht somit in Form und Ausdehnung der ersten Oberfläche des aufzubringenden Gehäuses.

Das Einbringen von Lotmaterial kann in through hole-Technologie mittels in dem Verdrahtungssubstrat angeordneten Vias erfolgen. Alternativ kann es auch mittels Einbringen von Lotdrahtstücken in den Zwischenraum zwischen Kühlkörper und Entwärmungsregion erfolgen.

Als Abstandshalter können beispielsweise Klebepunkte eines SMD-Klebstoffes verwendet werden.

Das Verfahren hat den Vorteil, dass es das Aufbringen einer besonders großen Lotmenge auf die Entwärmungsregion erlaubt. Es ist damit möglich, Lotschichtdicken zu erzielen, die mit Standarddruckverfahren nicht oder nur schwer erreichbar wären. Auf diese Weise wird eine besonders große Menge an gut wärmeleitendem Material in Kontakt mit dem Kühlkörper gebracht.

Ausführungsformen der Erfindung werden im Folgenden anhand schematischer Zeichnungen beispielhaft beschrieben.
- Figur 1: zeigt schematisch ein Leistungshalbleiterbauteil gemäß einer Ausführungsform der Erfindung im Querschnitt und
- Figur 2: zeigt schematisch das Leistungshalbleiterbauteil gemäß Figur 1 in einer Draufsicht.

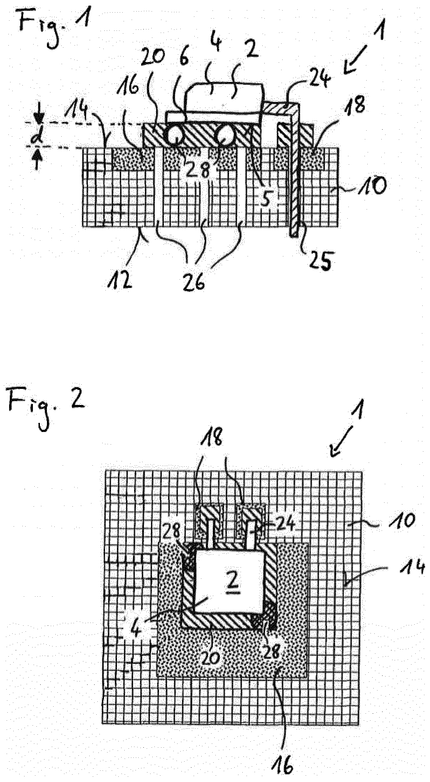

Das Leistungshalbleiterbauteil 1 gemäß Figur 1 weist ein Leistungshalbleiterbauelement 2 auf, von dem in Figur 1 lediglich ein Kunststoffgehäuse 4 gezeigt ist sowie aus dem Kunststoffgehäuse 4 herausragende Anschlusspins 24 sowie ein an einer ersten Oberfläche 5 des Gehäuses 4 freiliegender Kühlkörper 6. Das Leistungshalbleiterbauelement 2 weist darüber hinaus mindestens einen Leistungshalbleiterchip auf, beispielsweise einen MOSFET, der mit dem Kühlkörper 6 thermisch und gegebenenfalls auch elektrisch verbunden ist. Über die Anschlusspins 24 und gegebenenfalls über den Kühlkörper 6 wird das Leistungshalbleiterbauelement 2 elektrisch kontaktiert.

Bei der gezeigten Ausführungsform handelt es sich um ein durchsteckmontierbares Leistungshalbleiterbauelement 2. Alternativ könnte es sich jedoch auch um ein oberflächenmontierbares Leistungshalbleiterbauelement handeln.

Das Leistungshalbleiterbauteil 1 weist ferner ein Verdrahtungssubstrat 10 auf, das in der gezeigten Ausführungsform als PCB-Substrat ausgebildet ist und eine erste Hauptoberfläche 12 und eine dieser gegenüber liegende zweite Hauptoberfläche 14 aufweist. Das Verdrahtungssubstrat 10 weist im Wesentlichen eine Matrix aus Kunststoff auf, in die Kontaktanschlussflächen 18 für die Anschlusspins 24, nicht dargestellte Leiterbahnen sowie eine Entwärmungsregion 16 aus Kupfer eingebettet sind. Die Entwärmungsregion 16 liegt an einer zweiten Hauptoberfläche 14 des Verdrahtungssubstrats 10 frei und ist zur Aufnahme des Leistungshalbleiterbauelements 2 und zum Herstellen eines thermischen (und gegebenenfalls auch elektrischen) Kontakts mit dem Kühlkörper 6 vorgesehen.

Das Verdrahtungssubstrat 10 weist eine Anzahl von Vias 25, 26 auf. Dabei sind Vias 25 im Bereich von Kontaktanschlussflächen 18 als elektrische Vias zum Hindurchführen der Anschlusspins 24 vorgesehen. Vias 26 im Bereich der Entwärmungsregion 16 sind als thermische Vias ausgeführt und dienen unter anderem zur Abfuhr von Wärme.

Sowohl auf der Entwärmungsregion 16 als auch auf den Kontaktanschlussflächen 8 ist eine Lotschicht 20 zur elektrischen und mechanischen Verbindung von Leistungshalbleiterbauelement 2 und Verdrahtungssubstrat 10 aufgebracht. Das Leistungshalbleiterbauelement 2, insbesondere der Kühlkörper 6, ist mit der Entwärmungsregion 16 über die Lotschicht 20 elektrisch und thermisch leitend verbunden. Die Anschlusspins 24 sind mit den Kontaktanschlussflächen 18 über die Lotschicht 20 elektrisch und thermisch leitend verbunden.

Die Lotschicht 20 weist eine hohe Dicke d auf. Sie ist daher nicht, wie sonst meist üblich, auf das Verdrahtungssubstrat 10 aufgedruckt. Vielmehr wird zunächst das Gehäuse 4 mit dem Leistungshalbleiterbauelement 2 mittels Abstandshaltern 28, die in der gezeigten Ausführungsform SMD-Klebepunkte sind, auf die Entwärmungsregion 16 aufgesetzt und dort fixiert. Anschließend wird das Gehäuse 4 bzw. der an seiner ersten Oberfläche 5 freiliegende Kühlkörper 6 mittels through hole-Technologie mit der Entwärmungsregion 16 verlötet. Dabei wird Lotmaterial für die Lotschicht 20 von der ersten Hauptoberfläche 12 aus durch die Vias 26 in den Zwischenraum zwischen dem Kühlkörper 6 und dem Verdrahtungssubstrat 10 eingebracht. Gleichzeitig kann auch die Lotschicht 20 auf den Kontaktanschlussflächen 18 durch die Vias 25 aufgebracht werden. Da diese jedoch keine besonders große Dicke aufweisen muss, kann sie auch in einem Standardverfahren aufgedruckt sein.

Die Lotmenge und der Druck, mit der das Lot in den Zwischenraum gebracht wird, werden dabei so gesteuert, dass die Lotschicht 20 im Wesentlichen den ganzen Zwischenraum zwischen dem Kühlkörper 6 und dem Verdrahtungssubstrat 10 ausfüllt. Die Vias 26 können ebenfalls mit Lotmaterial aufgefüllt werden oder sie können freigehalten werden oder mit einem anderen, vorzugsweise gut wärmeleitenden Material gefüllt werden.

Figur 2 zeigt das Leistungshalbleiterbauteil 1 in einer Draufsicht. In dieser Ansicht ist erkennbar, dass die Entwärmungsregion 16 eine deutlich größere flächige Ausdehnung aufweist als das Gehäuse 4 bzw. der in Figur 2 nicht sichtbare Kühlkörper 6. In der gezeigten Ausführungsform ist die Fläche A der Entwärmungsregion 16 mehr als doppelt so groß wie die an der ersten Oberfläche 5 des Gehäuses 4 freiliegende Fläche a des Kühlkörpers 6.

Wie in Figur 2 erkennbar ist, ragt somit die Entwärmungsregion 16 seitlich erheblich über das Gehäuse 4 hinaus. In der in Figur 2 gezeigten Ausführungsform ragt sie an allen Seiten über das Gehäuse 4 hinaus.

Das Kupfermaterial der Entwärmungsregion 16 sowie auch das Lotmaterial der Lotschicht 20 bilden eine erhöhte thermische Masse, die sowohl kurzzeitige Temperaturerhöhungen durch Leistungsspitzen abpuffern kann als auch wegen ihrer großen räumlichen Ausdehnung eine gute Wärmespreizung erzielen kann.

## Patentansprüche

1. Leistungshalbleiterbauteil (1), aufweisend
- ein innerhalb eines Gehäuses (4) angeordnetes Leistungshalbleiterbauelement (2), wobei an einer ersten Oberfläche (5) des Gehäuses (4) ein Kühlkörper (6) freiliegt;
- ein das Gehäuse (4) mit dem Leistungshalbleiterbauelement (2) aufnehmendes Verdrahtungssubstrat (10) mit einer ersten Hauptoberfläche (12) und einer zweiten Hauptoberfläche (14), wobei auf der zweiten Hauptoberfläche (14) eine Entwärmungsregion (16) mit erhöhter Wärmeleitfähigkeit angeordnet ist;
wobei das Gehäuse (4) derart auf dem Verdrahtungssubstrat (10) angeordnet ist, dass der Kühlkörper (6) über eine Lotschicht (20) mit der Entwärmungsregion (16) verbunden ist, wobei in die Lotschicht (20) eine Anzahl von zwischen dem Kühlkörper (6) und der Entwärmungsregion (16) angeordneten Abstandshaltern (28) eingebettet sind und
**dadurch gekennzeichnet, dass**
die Abstandshalter (28) aus einem elektrisch und thermisch gut leitenden Material ausgebildet sind.

2. Leistungshalbleiterbauteil (1) nach Anspruch 1,
wobei das in dem Gehäuse (4) angeordnete Leistungshalbleiterbauelement (2) durchsteckmontierbar ausgebildet ist.

3. Leistungshalbleiterbauteil (1) nach einem der vorhergehenden Ansprüche,
wobei das Verdrahtungssubstrat (10) eine Anzahl von Vias (26) aufweist, durch die das Lotmaterial zwischen den Kühlkörper (6) und die Entwärmungsregion (16) des Verdrahtungssubstrats (10) eingebracht ist.

4. Leistungshalbleiterbauteil (1) nach Anspruch 1,
wobei das in dem Gehäuse (4) angeordnete Leistungshalbleiterbauelement (2) oberflächenmontierbar ausgebildet ist.

5. Leistungshalbleiterbauteil (1) nach einem der vorhergehenden Ansprüche, wobei das Gehäuse (4) mit dem Leistungshalbleiterbauelement (2) mittels der Abstandshalter (28) und mittels Lotschicht (20) mit der Entwärmungsregion (16) elektrisch verbunden ist.

6. Leistungshalbleiterbauteil (1) nach einem der vorhergehenden Ansprüche, wobei der Kühlkörper (6) eine Fläche a auf der ersten Oberfläche (5) aufweist und die Entwärmungsregion (16) eine Fläche A auf der zweiten Hauptoberfläche (14) aufweist, wobei a < A gilt.

7. Verfahren zur Herstellung eines Leistungshalbleiterbauteils (1) gemäß einem der vorhergehenden Ansprüche, das folgendes aufweist:
- Bereitstellen eines innerhalb eines Gehäuses (4) angeordneten Leistungshalbleiterbauelements (2), wobei an einer ersten Oberfläche (5) des Gehäuses (4) ein Kühlkörper (6) freiliegt;
- Bereitstellen eines Verdrahtungssubstrats (10) mit einer ersten Hauptoberfläche (12) und einer zweiten Hauptoberfläche (14), wobei auf der zweiten Hauptoberfläche (14) eine Entwärmungsregion (16) mit erhöhter Wärmeleitfähigkeit angeordnet ist;
- Aufbringen einer Anzahl von Abstandshaltern (28) in der einer Montageregion der Entwärmungsregion (16) auf das Verdrahtungssubstrat (10) und Aufsetzen des Gehäuses (4) mit dem Leistungshalbleiterbauelement (2) in der Montageregion auf die Abstandshalter (28);
- nachfolgendes Einbringen von Lotmaterial in einen Zwischenraum zwischen dem Kühlkörper (6) und der Entwärmungsregion (16).

8. Verfahren nach Anspruch 7,
wobei das Einbringen von Lotmaterial mittels in dem Verdrahtungssubstrat (10) angeordneten Vias (26) erfolgt.

9. Verfahren nach Anspruch 7,
wobei das Einbringen von Lotmaterial mittels Einbringen von Lotdrahtstücken erfolgt.

10. Verfahren nach einem der Ansprüche 7 bis 9,
wobei als Abstandshalter (28) Klebepunkte eines SMD-Klebstoffes verwendet werden.

## Claims

1. Power semiconductor component (1), having
- a power semiconductor device (2) arranged within a housing (4), wherein a heat sink (6) is exposed on a first surface (5) of the housing (4);
- a wiring substrate (10) which receives the housing (4) with the power semiconductor device (2) and which has a first main surface (12) and a second main surface (14), wherein a heat dissipation region (16) with increased thermal conductivity is arranged on the second main surface (14);
wherein the housing (4) is arranged on the wiring substrate (10) in such a way that the heat sink (6) is connected to the heat dissipation region (16) via a solder layer (20), wherein a number of spacers (28) which are arranged between the heat sink (6) and the heat dissipation region (16) are embedded in the solder layer (20), and
**characterized in that** the spacers (28) are formed from a material that has good electrical and thermal conductivity.

2. Power semiconductor component (1) according to Claim 1,
wherein the power semiconductor device (2) arranged in the housing (4) is designed to be through-hole-mountable.

3. Power semiconductor component (1) according to either of the preceding claims,
wherein the wiring substrate (10) has a number of vias (26) through which the solder material is introduced between the heat sink (6) and the heat dissipation region (16) of the wiring substrate (10) .

4. Power semiconductor component (1) according to Claim 1,
wherein the power semiconductor device (2) arranged in the housing (4) is designed to be surface-mountable.

5. Power semiconductor component (1) according to one of the preceding claims,
wherein the housing (4) with the power semiconductor device (2) is electrically connected to the heat dissipation region (16) by means of the spacers (28) and by means of a solder layer (20).

6. Power semiconductor component (1) according to one of the preceding claims,
wherein the heat sink (6) has an area a on the first surface (5) and the heat dissipation region (16) has an area A on the second main surface (14), where a < A applies.

7. Method for producing a power semiconductor component (1) according to one of the preceding claims, comprising the following:
- providing a power semiconductor device (2) arranged within a housing (4), wherein a heat sink (6) is exposed on a first surface (5) of the housing (4) ;
- providing a wiring substrate (10) having a first main surface (12) and a second main surface (14), wherein a heat dissipation reckon (16) with increased thermal conductivity is arranged on the second main surface (14);
- applying a number of spacers (28) to the wiring substrate (10) in a mounting region of the heat dissipation region (16), and placing the housing (4) with the power semiconductor device (2) onto the spacers (28) in the mounting region;
- subsequently introducing solder material into an intermediate space between the heat sink (6) and the heat dissipation region (16).

8. Method according to Claim 7,
wherein solder material is introduced by means of vias (26) arranged in the wiring substrate (10).

9. Method according to Claim 7,
wherein solder material is introduced by introducing pieces of solder wire.

10. Method according to one of Claims 7 to 9,
wherein adhesive spots of an SMD adhesive are used as spacers (28).

## Revendications

1. Composant semi-conducteur de puissance (1), présentant
- un élément semi-conducteur de puissance (2) disposé à l'intérieur d'un boîtier (4), un dissipateur thermique (6) étant exposé au niveau d'une première surface (5) du boîtier (4) ;
- un substrat de câblage (10) recevant le boîtier (4) avec l'élément semi-conducteur de puissance (2) et muni d'une première surface principale (12) et d'une deuxième surface principale (14), dans lequel une région de dissipation thermique (16) à conductibilité thermique accrue est disposée sur la deuxième surface principale (14) ;
dans lequel le boîtier (4) est disposé sur le substrat de câblage (10) de telle sorte que le dissipateur thermique (6) est relié à la région de dissipation thermique (16) par l'intermédiaire d'une couche de brasure (20), dans lequel un certain nombre d'écarteurs (28), disposés entre le dissipateur thermique (6) et la région de dissipation thermique (16), est incorporé dans la couche de brasure (20), et
**caractérisé en ce que** les écarteurs (28) sont réalisés dans un matériau ayant une bonne conductibilité électrique et thermique.

2. Composant semi-conducteur de puissance (1) selon la revendication 1, dans lequel l'élément semi-conducteur de puissance (2) disposé dans le boîtier (4) peut être monté de manière traversante.

3. Composant semi-conducteur de puissance (1) selon l'une quelconque des revendications précédentes, dans lequel le substrat de câblage (10) présente un certain nombre de trous d'interconnexion (26) à travers lesquels le matériau de brasure est introduit entre le dissipateur thermique (6) et la région de dissipation thermique (16) du substrat de câblage (10).

4. Composant semi-conducteur de puissance (1) selon la revendication 1, dans lequel l'élément semi-conducteur de puissance (2) disposé dans le boîtier (4) est réalisé de manière à pouvoir être monté en surface.

5. Composant semi-conducteur de puissance (1) selon l'une quelconque des revendications précédentes, dans lequel le boîtier (4) est relié électriquement à l'élément semi-conducteur de puissance (2) au moyen des écarteurs (28) et est relié électriquement à la région de dissipation thermique (16) au moyen de la couche de brasure (20).

6. Composant semi-conducteur de puissance (1) selon l'une quelconque des revendications précédentes, dans lequel le dissipateur thermique (6) présente une superficie a sur la première surface (5) et la région de dissipation thermique (16) présente une superficie A sur la deuxième surface principale (14), où a < A.

7. Procédé de fabrication d'un composant semi-conducteur de puissance (1) selon l'une quelconque des revendications précédentes, présentant les étapes suivantes consistant à :
- fournir un élément semi-conducteur de puissance (2) disposé à l'intérieur d'un boîtier (4), un dissipateur thermique (6) étant exposé au niveau d'une première surface (5) du boîtier (4) ;
- fournir un substrat de câblage (10) muni d'une première surface principale (12) et d'une deuxième surface principale (14), dans lequel une région de dissipation thermique (16) à conductibilité thermique accrue est disposée sur la deuxième surface principale (14) ;
- appliquer un certain nombre d'écarteurs (28) dans une région de montage de la région de dissipation thermique (16) sur le substrat de câblage (10), et poser le boîtier (4) avec l'élément semi-conducteur de puissance (2) dans la région de montage sur les écarteurs (28) ;
- introduire ensuite un matériau de brasure dans un espace entre le dissipateur thermique (6) et la région de dissipation thermique (16).

8. Procédé selon la revendication 7, dans lequel l'introduction d'un matériau de brasure est effectuée au moyen de trous d'interconnexion (26) disposés dans le substrat de câblage (10).

9. Procédé selon la revendication 7, dans lequel l'introduction d'un matériau de brasure est effectuée au moyen de l'introduction de moreaux de fil d'apport.

10. Procédé selon l'une quelconque des revendications 7 à 9, dans lequel des points de collage d'un adhésif SMD sont utilisés comme écarteurs (28).
